(19) Europäisches Patentamt

European Patent Office

Office européen des brevets

(11) **EP 1 383 239 A1**

(12) **DEMANDE DE BREVET EUROPEEN**

(43) Date de publication:
**21.01.2004 Bulletin 2004/04**

(51) Int Cl.⁷: **H03J 7/02**

(21) Numéro de dépôt: **02015921.6**

(22) Date de dépôt: **17.07.2002**

(84) Etats contractants désignés:
**AT BE BG CH CY CZ DE DK EE ES FI FR GB GR IE IT LI LU MC NL PT SE SK TR**
Etats d'extension désignés:
**AL LT LV MK RO SI**

(71) Demandeur: **STMicroelectronics N.V.**
**1077 XX Amsterdam (NL)**

(72) Inventeurs:
• **Kirsch, Miguel**
**1296 Coppet (CH)**
• **Berens, Friedbert**
**1202 Geneve (CH)**

(74) Mandataire: **Zapalowicz, Francis**
**Bureau D.A. Casalonga-Josse,**
**Paul-Heyse-Strasse 33**
**80336 München (DE)**

(54) **Procédé et dispositif de contrôle automatique de la fréquence dans un récepteur du type DS-CDMA**

(57) On reçoit un signal connu à spectre fréquentiel étalé que l'on transforme en un signal numérique échantillonné formé de symboles et à spectre fréquentiel désétalé, on détermine pour chaque symbole une erreur fréquentielle résiduelle $f_e$, on filtre FLT cette erreur et on corrige la fréquence de l'oscillateur local VCO avec cette erreur filtrée. On mémorise la première erreur fréquentielle résiduelle déterminée $f_{e1}$, on détermine la moyenne des valeurs absolues d'un nombre prédéterminé d'erreurs fréquentielles résiduelles successives, on compare cette moyenne à un seuil prédéterminé, et si cette moyenne est supérieure ou égale audit seuil, on corrige la fréquence de l'oscillateur local avec une erreur égale à $-\text{sgn}(f_{e1})(1/T - |f_{e1}|)$, où sgn est la fonction « signe », | | la fonction valeur absolue et T la durée d'un symbole, avant de déterminer l'erreur fréquentielle résiduelle suivante associée au symbole suivant.

FIG.1

**Description**

L'invention concerne d'une façon générale les systèmes de communication sans fil, notamment ceux destinés à fonctionner selon la norme CDMA, et plus particulièrement le contrôle automatique de la fréquence d'un oscillateur local d'un récepteur du type DS-CDMA.

Dans un système de communication sans fil, une station de base communique avec une pluralité de terminaux distants, tels que des téléphones mobiles cellulaires. Les accès multiples par division de fréquence (FDMA : "Frequency-Division Multiple Access" en langue anglaise) et les accès multiples par division temporelle (TDMA : "Time Division Multiple Access" en langue anglaise) sont les schémas d'accès multiples traditionnels pour délivrer des services simultanés à un certain nombre de terminaux. L'idée de base sous-jacente aux systèmes FDMA et TDMA consiste à partager la ressource disponible, respectivement en plusieurs fréquences ou en plusieurs intervalles temporels, de telle sorte que plusieurs terminaux peuvent fonctionner simultanément sans provoquer d'interférence.

Les téléphones fonctionnant selon la norme GSM appartiennent aux systèmes FDMA et TDMA en ce sens que l'émission et la réception s'effectuent à des fréquences différentes et également à des intervalles temporels différents.

A l'opposé de ces systèmes utilisant une division de fréquence ou une division temporelle, les systèmes CDMA (Système à accès multiples par division de code; "Code Division Multiple Access" en langue anglaise) permettent aux utilisateurs multiples de partager une fréquence commune et un canal temporel commun en utilisant une modulation codée. Parmi les systèmes CDMA on peut citer le système CDMA 2000, le système WCDMA ("Wide Band CDMA" en langue anglaise; CDMA large bande) ou la norme IS-95.

Dans les systèmes CDMA, comme il est bien connu par l'homme du métier, un code d'embrouillage ("scrambling code" en langue anglaise) est associé à chaque station de base et permet de distinguer une station de base d'une autre. En outre, un code orthogonal, connu par l'homme du métier sous la dénomination de "Code OVSF", est alloué à chaque terminal distant (comme par exemple un téléphone mobile cellulaire). Tous les codes OVSF sont orthogonaux entre eux, ce qui permet de distinguer un terminal distant d'un autre.

Avant d'émettre un signal sur le canal de transmission à destination d'un terminal distant, le signal a été embrouillé et étalé ("spread" en langue anglaise) par la station de base en utilisant le code d'embrouillage de la station de base et le code OVSF du terminal distant. En conséquence les symboles du signal sont transformés en fragments (« chips »). La fréquence « fragment » (chip rate) est plus élevée que la fréquence symbole (« symbol rate »).

Les systèmes CDMA utilisant des signaux à spectre fréquentiel étalé (spread) sont connus par l'homme du métier sous la dénomination de systèmes DS-CDMA.

L'invention s'applique plus particulièrement aux récepteurs de tels systèmes.

Un tel récepteur comprend, de façon classique, un étage analogique radiofréquence connecté à une antenne pour recevoir un signal d'entrée à spectre fréquentiel étalé.

Classiquement, l'étage radiofréquence comprend un amplificateur faible bruit, et deux voies de traitement comportant des mélangeurs, des filtres et amplificateurs classiques. Les deux mélangeurs reçoivent respectivement de la part d'une boucle à verrouillage de phase comportant un oscillateur local, deux signaux présentant mutuellement une différence de phase de 90°C. Après transposition de fréquence dans les mélangeurs, les deux voies de traitement définissent deux flux I et Q (flux direct et flux en quadrature) selon une dénomination bien connue de l'homme du métier. Le signal a alors été transposé dans la bande fréquentielle de base du signal. Après conversion numérique dans les convertisseurs analogique/numérique, les deux flux I et Q sont délivrés à un étage de traitement de réception qui comprend, de façon classique, un récepteur « Rake » selon une dénomination communément adoptée par l'homme du métier. Le récepteur « Rake », qui équipe par exemple les téléphones mobiles cellulaires fonctionnant dans un système de communication DS-CDMA, est utilisé pour effectuer l'alignement temporel, le désembrouillage, le désétalement et la combinaison des versions retardées des signaux initiaux, de façon à délivrer les flux d'information contenus dans les signaux initiaux.

La transposition fréquentielle du signal reçu en bande de base, conduit la plupart du temps à une imprécision, principalement due à la qualité de l'oscillateur local, provoquant alors une erreur de décalage fréquentiel résiduel.

L'étage de traitement numérique des récepteurs comporte alors généralement un algorithme de contrôle automatique de fréquence (AFC : automatic frequency control) dont le rôle est de minimiser cette erreur de fréquence résiduelle de façon à la ramener à une valeur acceptable qui n'aura pas de conséquence sur le traitement ultérieur du signal.

Plusieurs méthodes de correction fréquentielle existent actuellement.

Des techniques de contrôle automatique de fréquence utilisées dans les communications en bande étroite peuvent être employées pour le contrôle de fréquences après désétalement. On peut citer par exemple

- A.N. D'Andrea and U. Mengali, « Design of quadricorrelators for automatic frequency control systems », IEEE *Trans. Commun.,* vol. 41, pp. 988-997, Jan. 1993. ;

- M.L. Fowler and J.A. Johnson, « Extending the threshold and frequency range for phase-based frequency estimation », IEEE *Trans. Signal Processing.,* vol. 47, pp. 2857-2863, Oct. 1999. ;
- A. Wannasarnmaytha, S. Hara and N. Morinaga. « Two-step-Kalman-Filter_Based AFC for Direct Conversation-type receiver in LEO satellite Communications », IEEE *Trans. Commun.,* vol. 49, pp. 246-253, Jan. 2000.

Cependant, les performances de ces techniques ne satisfont pas à un certain nombre d'exigences des récepteurs de la troisième génération destinés à fonctionner sous la norme CDMA, comme par exemple une large plage fréquentielle de correction, une correction rapide et une faible complexité de réalisation.

Plus précisément, les plages de correction des techniques de contrôle automatique de fréquences utilisées en bande étroite s'avèrent insuffisantes lorsque la fréquence est élevée et que le décalage fréquentiel est de l'ordre de la fréquence symbole (symbol rate) comme par exemple dans les systèmes de communication sans fil de la troisième génération.

Certes, des techniques de contrôle automatique de fréquence à filtres duals, et à quadricorrélateur équilibré ( A.N. D'Andrea and U. Mengali, « Design of quadricorrelators for automatic frequency control systems », IEEE *Trans. Commun.,* vol. 41, pp. 988-997, Jan.1993.) ont des plages de correction de l'ordre de la fréquence symbole. Cependant, ces approches impliquent l'utilisation de filtres compliqués pour supprimer le bruit inductif et requièrent une connaissance précise du canal de transmission.

D'autres techniques de contrôle automatique de fréquence (Jing Lei and Tung-Sang Ng, », New AFC Algorithm For A Fully-Digital MDPSK DS/CDMA Receiver », ISCAS 2001, vol. 4, pp. 294-297.) présentent également des plages de correction de l'ordre de la fréquence symbole, mais présentent une très forte complexité de réalisation en raison du fait qu'elles doivent être appliquées avant le désétalement du signal.

L'invention vise à apporter une solution à ces problèmes.

L'invention a pour but de proposer un contrôle automatique de la fréquence d'un oscillateur local d'un récepteur du type DS-CDMA présentant une faible complexité de réalisation, fonctionnant au niveau symbole avec une plage de correction de l'ordre de la fréquence symbole, ce qui est sensiblement le double de la plage de correction des techniques automatiques de contrôle à bande étroite.

L'invention a également pour but de proposer un tel contrôle automatique de fréquence qui présente une convergence beaucoup plus rapide et beaucoup plus précise que les contrôles automatiques de fréquence actuels.

L'invention propose donc un procédé de contrôle automatique de la fréquence d'un oscillateur local d'un récepteur du type DS-CDMA, dans lequel on reçoit un signal connu (par exemple un signal « pilote ») à spectre fréquentiel étalé que l'on transforme en un signal numérique échantillonné formé de symboles et à spectre fréquentiel désétalé. On détermine pour chaque symbole une erreur fréquentielle résiduelle, on filtre cette erreur et on corrige la fréquence de l'oscillateur local avec cette erreur filtrée.

Selon une caractéristique générale de l'invention, on mémorise la première erreur fréquentielle résiduelle déterminée $f_{e1}$, on détermine la moyenne des valeurs absolues d'un nombre prédéterminé d'erreurs fréquentielles résiduelles successives, on compare cette moyenne à un seuil prédéterminé, et si cette moyenne est supérieure audit seuil, on corrige la fréquence de l'oscillateur local avec une erreur égale à $-\text{sgn}(f_{e1})(1/T - |f_{e1}|)$, où sgn est la fonction " signe ", $| \quad |$ la fonction valeur absolue et T la durée d'un symbole, avant de déterminer l'erreur fréquentielle résiduelle suivante associée au symbole suivant.

Le filtrage des erreurs fréquentielles résiduelles étant avantageusement un filtrage numérique, si la moyenne est supérieure audit seuil, on met alors à 0 la mémoire du filtre numérique avant de filtrer ladite erreur fréquentielle résiduelle suivante.

On filtre avantageusement les erreurs fréquentielles résiduelles avec un filtre adaptatif du premier ordre.

Plus précisément, lorsque l'erreur fréquentielle résiduelle estimée est importante, cette erreur estimée n'est à la limite pas filtrée. Ceci conduit à une convergence rapide vers la valeur du décalage fréquentiel, mais, bien entendu, une fois que cette valeur est atteinte, les oscillations autour de celle-ci sont importantes. Aussi, pour résoudre ce problème, lorsque l'erreur fréquentielle décroît, la bande passante du filtre adaptatif diminue.

Ainsi, selon un mode de mise en oeuvre, la correction courante appliquée à l'oscillateur local est égale à (1-b) fois la correction précédente plus b fois l'erreur fréquentielle résiduelle courante, et le coefficient b est choisi proche de 1 si l'erreur fréquentielle résiduelle courante est supérieure à une première valeur limite prédéterminée, tandis que le coefficient b est choisi proche de 0 si l'erreur fréquentielle résiduelle courante est inférieure à une deuxième valeur limite prédéterminée.

A titre indicatif, ladite première valeur limite prédéterminée est par exemple égale à la fréquence symbole divisée par 7.

La première et la deuxième valeurs limites peuvent être identiques ou différentes. Dans ce cas, on peut envisager plusieurs valeurs limites intermédiaires entre ces deux valeurs, par exemple stockées dans une table, et permettant une décroissance par paliers de la valeur de b.

L'invention a également pour objet un dispositif de contrôle automatique de la fréquence d'un oscillateur local d'un récepteur du type DS-CDMA, comprenant une entrée pour recevoir un signal connu à spectre fréquentiel étalé, des moyens de prétraitement aptes à transformer ce signal en un signal numérique échantillonné formé de symboles et à spectre fréquentiel désétalé, des premiers moyens de calcul aptes à déterminer pour chaque symbole une erreur fréquentielle résiduelle, des moyens de filtrage aptes à filtrer cette erreur et des moyens de correction pour corriger la fréquence de l'oscillateur local avec cette erreur filtrée. Selon une caractéristique générale de l'invention, le dispositif comporte en outre une mémoire pour mémoriser la première erreur fréquentielle résiduelle déterminée $f_{e1}$, des deuxièmes moyens de calcul aptes à déterminer la moyenne des valeurs absolues d'un nombre prédéterminé d'erreurs fréquentielles résiduelles successives, des moyens de comparaison aptes à comparer cette moyenne à un seuil prédéterminé, et si cette moyenne est supérieure audit seuil, les moyens de correction corrigent la fréquence de l'oscillateur local avec une erreur égale à $-\mathrm{sgn}(f_{e1})(1/T - |f_{e1}|)$, où sgn est la fonction " signe " , $|\,|$ la fonction valeur absolue et T la durée d'un symbole, avant que les premiers moyens de calcul ne déterminent l'erreur fréquentielle résiduelle suivante associée au symbole suivant.

Selon un mode de réalisation de l'invention, les moyens de filtrage comporte un filtrage numérique, et le dispositif comporte des moyens de contrôle aptes, si la moyenne est supérieure au seuil, à mettre à zéro la mémoire du filtre numérique avant de filtrer ladite erreur fréquentielle résiduelle suivante.

L'invention a également pour objet un récepteur du type DS-CDMA, comportant un dispositif de contrôle automatique de fréquence tel que défini ci-avant. Un tel récepteur peut être par exemple un téléphone mobile cellulaire.

D'autres avantages et caractéristiques de l'invention apparaîtront à l'examen de la description détaillée de modes de réalisation et de mise en oeuvre, nullement limitatifs, et des dessins annexés sur lesquels :

- la figure 1 représente schématiquement un mode de réalisation et un dispositif selon l'invention, permettant une mise en oeuvre du procédé selon l'invention, et,
- la figure 2 illustre deux courbes montrant l'un des problèmes résolus par l'invention.

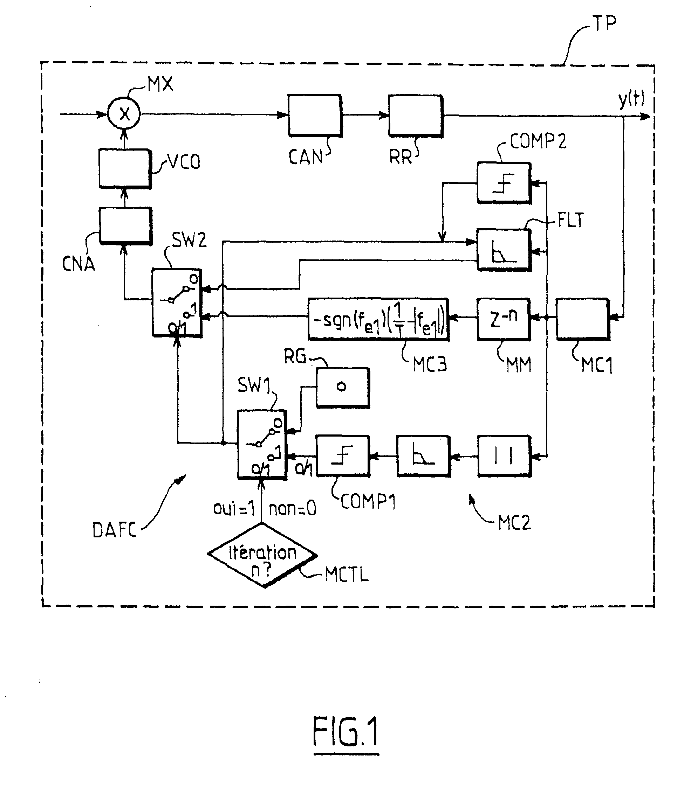

Sur la figure 1, la référence TP désigne un téléphone mobile cellulaire appartenant à un système de communication sans fil du type DS-CDMA. L'étage analogique de réception de ce téléphone TP comporte de façon classique un mélangeur MX recevant le signal incident de l'antenne, ce mélangeur étant précédé et suivi d'amplificateurs non représentés ici à des fins de simplification.

De même, on a représenté sur la figure 1, à des fins de simplification, une seule des voies de traitement, par exemple la voie de traitement I.

Le signal de transposition de fréquence est issu d'une boucle à verrouillage de phases comportant un oscillateur local commandé en tension et référencé VCO.

Après transposition de fréquences dans le mélangeur MX et conversion analogique numérique dans un convertisseur analogique numérique CAN, le signal est un signal numérique en bande de base, échantillonné à une fréquence d'échantillonnage bien supérieure à la fréquence symbole égale à $1/T$ (T étant la durée d'un symbole).

Ce signal numérique est ensuite délivré à un récepteur Rake RR qui effectue notamment le désétalement fréquentiel (« despreading ») du signal.

Ainsi, si l'on considère que le signal d'entrée du mélangeur est la séquence du signal pilote, le signal y(k) peut être modélisé, après désétalement de la séquence pilote par la formule (I) ci-dessous.

$$y(k) = \beta b(k) A e^{j(\varphi(k)+\Phi(k)+2\pi f_e k)} + \eta(k) \qquad (I)$$

Dans cette formule :

- $Ae^{j\varphi(k)}$ est la séquence transmise du pilote, A étant un réel,
- $e^{j\varphi(k)}$ est la distorsion de phase du canal de transmission,
- $b(k)$ est la distorsion d'amplitude du canal,
- $f_e$ est l'erreur fréquentielle résiduelle,
- $\eta(k)$ est un bruit complexe et $\beta$ est un coefficient réel d'atténuation compris entre 0 et 1 qui décroît lorsque l'erreur fréquentielle résiduelle $f_e$ croît.

L'étage numérique du téléphone mobile TP est alors pourvu d'un dispositif de contrôle automatique de fréquence DAFC, essentiellement réalisé de façon logicielle au sein d'un processeur, et dont le rôle est d'estimer les erreurs fréquentielles successives $f_e$ respectivement associées aux symboles successifs, et de contrôler, après conversion numérique analogique dans un convertisseur CNA, l'oscillateur VCO de façon à réduire au maximum cette erreur fréquentielle résiduelle. Plus précisément on corrige la tension de l'oscillateur de façon à contrôler sa fréquence, c'est-à-dire la fréquence du signal de transposition délivré par cet oscillateur.

Le dispositif DAFC comporte des premiers moyens de calcul MC1, réalisés de façon logicielle, et aptes à déterminer pour chaque symbole, une erreur fréquentielle résiduelle $f_e$. La détermination de ces erreurs fréquentielles successives s'effectue de façon classique par une autocorrélation de deux symboles consécutifs. Ceci est parfaitement connu de l'homme du métier et on n'y reviendra donc pas plus en détail ici.

D'une façon générale, et sauf exception qui sera décrite en détail ci-après, chaque erreur fréquentielle résiduelle est filtrée par un filtre numérique passe-bas FLT.

Des moyens de correction, comportant ici un convertisseur numérique analogique CNA vont ensuite corriger la fréquence de l'oscillateur local avec cette erreur filtrée.

Plusieurs cas sont alors à envisager.

Lorsque la première erreur fréquentielle résiduelle déterminée est inférieure à la moitié de la fréquence symbole, c'est-à-dire inférieure à 1/2T, les corrections effectuées par le dispositif DAFC sont bonnes et permettent une convergence vers 0 des valeurs absolues des erreurs fréquentielles résiduelles successives.

Ceci n'est pas le cas lorsque la première erreur fréquentielle résiduelle déterminée est supérieure à 1/2T. Ceci étant, l'invention va remédier à ce problème comme on va maintenant le décrire plus en détail.

Si l'on considère une séquence du signal pilote désétalé dans le domaine fréquentiel, on observe alors que, puisque la séquence de pilote a une valeur constante et que le procédé de désétalement implique une opération de moyennage et de sous-échantillonnage, le procédé dans sa globalité peut être vu comme la convolution dans le domaine temporel de la séquence pilote avec une fonction rectangle sur une longueur temporelle égale à la durée d'un symbole T, suivie d'un sous-échantillonnage depuis la fréquence fragment (« chip rate ») vers la fréquence symbole 1/T.

Ce procédé conduit dans le domaine fréquentiel à un spectre résultant en le produit d'un dirac (dû à la valeur constante de la séquence pilote) avec une fonction (sin x)/x dont le lobe principal a une largeur égale à 1/T, plus toutes les répliques de ce spectre, décalées fréquentiellement de k/T, et sommées ensemble (pour chaque valeur entière de k).

Lorsqu'il y a une erreur de décalage fréquentiel, la densité spectrale obtenue après désétalement n'est pas modifiée mais le dirac correspondant à la séquence pilote est décalé de l'origine d'un décalage correspondant à ladite erreur.

Lorsque l'erreur fréquentielle résiduelle est inférieure à 1/2T, il n'y a pas de phénomène de repliement de spectre, et on obtiendra alors la convergence des erreurs successives vers 0, comme indiqué ci-avant.

Par contre, lorsque la valeur absolue de l'erreur fréquentielle résiduelle est plus grande que 1/2T, il y a un phénomène de repliement de spectre.

Supposons par exemple, que l'on ait un décalage fréquentiel égal à -1/2T-$\Delta$f, avec 0 < $\Delta$f < à 1/2T.

En raison du repliement, cette erreur fréquentielle sera interprétée à tort comme étant égale à 1/2T-$\Delta$f.

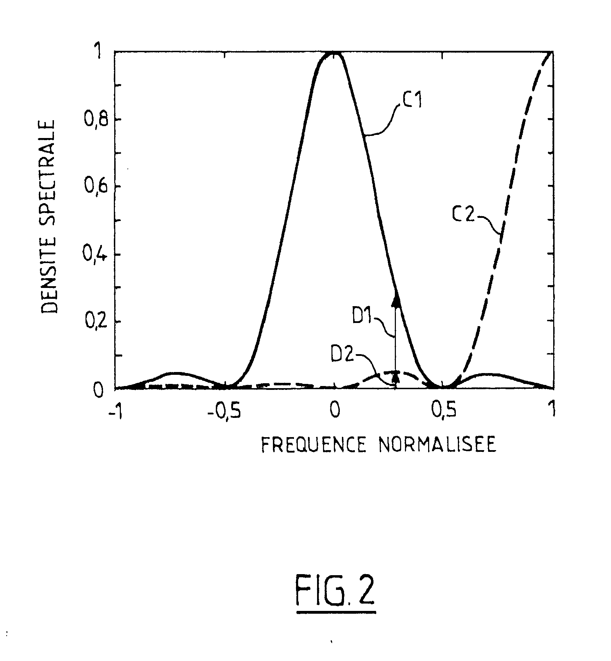

Ceci est illustré sur la figure 2 sur laquelle on peut observer la superposition du dirac D1 correspondant à l'erreur fréquentielle égale à 1/2T-$\Delta$f et du dirac D2 correspondant à l'erreur fréquentielle égale à -1/2T-$\Delta$f.

On observe sur cet exemple qu'il y a également une différence importante de puissance entre le dirac replié D2 et le dirac non replié D1.

Avec le signal non replié, l'estimation de l'erreur fréquentielle sera correcte et sa compensation va conduire le dirac D1 à se décaler vers la gauche vers une erreur fréquentielle nulle en suivant la courbe CI et en augmentant son énergie.

Cependant, compenser l'erreur fréquentielle mal interprétée du signal replié va conduire aussi à décaler le dirac D2 vers la gauche vers l'origine mais en augmentant l'erreur fréquentielle. Et, cette fois, l'énergie déjà basse du signal va décroître vers 0 en suivant la courbe C2.

La décroissance du rapport signal sur bruit du signal replié sera tellement importante que l'estimation de l'erreur fréquentielle sera très mauvaise, ce qui va conduire à de larges variations dans les estimations des erreurs fréquentielles successives.

Et, selon l'invention, c'est cette grande variation des erreurs fréquentielles résiduelles qui va être utilisée pour détecter et corriger des erreurs fréquentielles plus grandes que la fréquence de Nyquist, c'est-à-dire plus grandes que 1/2T.

On va maintenant décrire plus en détail ce point en se référant à nouveau plus particulièrement à la figure 1.

Le dispositif DAFC comporte des moyens de mémoire MM destinés à mémoriser la première erreur fréquentielle résiduelle déterminée $f_{e1}$. Par ailleurs, des moyens de calcul MC3 vont calculer une erreur fréquentielle $f_{e1}{}'$ définie par la formule (II) ci-dessous :

$$f_{e1}' = -\operatorname{sgn}(f_{e1})\left(\frac{1}{T} - |f_{e1}|\right) \qquad (II)$$

Dans cette formule, sgn désigne la fonction signe.

Par ailleurs, des deuxièmes moyens de calcul MC2 formés d'un bloc « valeur absolue » suivi d'un filtre passe-bas, vont déterminer la moyenne des valeurs absolues d'un nombre prédéterminé d'erreurs fréquentielles résiduelles successives.

Plus précisément, la moyenne courante z(k) est définie par la formule (III) ci-dessous :

$$z(k) = \frac{1}{2}z(k-1) + \frac{1}{2}|x(k)| \qquad (III)$$

dans laquelle k désigne l'itération courante correspondant au symbole courant et x(k) est l'erreur fréquentielle résiduelle courante fournie par les moyens MC1.

Des moyens de comparaison COMF1 sont aptes à comparer la moyenne courante délivrée par les moyens de calcul MC2 avec un seuil prédéterminé.

Si cette moyenne est inférieure au seuil, les moyens de comparaison COMP1 délivrent la valeur 0, tandis que si cette moyenne est supérieure au seuil, les moyens COMP1 délivrent la valeur 1.

Au bout d'un nombre prédéterminé d'itérations, c'est-à-dire de symboles, par exemple 5 ou 6, on examine le résultat de la comparaison effectuée par les moyens COMP1.

Bien que cette étape soit réalisée de façon logicielle, celle-ci est représentée schématiquement sur la figure 1 par un registre RG contenant une valeur constante égale à 0, et par un commutateur SW1 capable d'être commuté sur son entrée 0 ou son entrée 1 en fonction de la valeur d'un signal de commande délivré par des moyens de contrôle MCTL.

Plus précisément, tant que l'on n'a pas atteint le nombre prédéterminé d'itérations, la valeur du signal de commande est égale à 0, ce qui place le commutateur SW1 sur l'entrée correspondante. De ce fait, la valeur 0 est délivrée sur l'entrée de commande d'un deuxième commutateur SW2. Celui-ci est alors positionné sur son entrée 0, ce qui met en relation la sortie du filtre FLT avec le convertisseur numérique analogique CNA.

Par contre, lorsque le nombre prédéterminé d'itérations est atteint, les moyens de contrôle confèrent la valeur logique 1 au signal de commande commandant le commutateur SW1. Celui-ci se positionne sur son entrée 1. La valeur du signal de commande du commutateur SW2 est alors fixée par la valeur délivrée par le comparateur COMP1.

Si cette valeur est à 0, correspondant à une moyenne inférieure au seuil, cela signifie qu'il y a convergence des erreurs fréquentielles résiduelles successives. Par conséquent, la sortie du filtre FLT reste reliée au convertisseur numérique analogique CNA.

Si par contre la valeur logique délivrée par le comparateur COMP1 est à 1, ceci signifie que la moyenne des valeurs absolues des erreurs fréquentielles successives est supérieure au seuil. Il n'y a donc pas convergence. En conséquence, cela signifie, avec une très forte probabilité, que la première erreur fréquentielle résiduelle mémorisée $f_{e1}$ n'était pas l'erreur fréquentielle réelle mais sa version repliée.

Dans ce cas, le commutateur SW2 est placé sur son entrée 1 et la correction de l'oscillateur local VCO est effectuée avec l'erreur fréquentielle résiduelle $f_{e1}'$ déterminée par les moyens de calcul MC3.

Une fois cette nouvelle correction appliquée, les erreurs fréquentielles résiduelles suivantes retombent à une valeur inférieure à la fréquence de Nyquist et le cycle normal recommence avec le commutateur SW2 positionné sur l'entrée 0 et le commutateur SW1 positionné sur l'entrée 0. Il y a alors convergence vers 0 des erreurs fréquentielles résiduelles.

Ceci étant, avant de filtrer l'erreur fréquentielle résiduelle déterminée juste après avoir appliquer la correction $f_{e1}'$, on remet à 0 la mémoire du filtre FLT.

A titre indicatif, avec un système du type DS-CDMA ayant une fréquence porteuse de 2 GHz et une fréquence symbole du signal piloté de 15 kHz, ce qui conduit à une fréquence de Nyquist de 7,5 kHz, on prend en compte la valeur délivré par le comparateur COMP1 après 5 itérations et la valeur du seuil est fixée à 500 Hz.

Le filtre numérique FLT est un filtre passe-bas du premier ordre. Plus précisément, l'erreur fréquentielle estimée courante c(k) délivrée en sortie du filtre (c'est-à-dire la correction courante numérique appliquée à l'oscillateur), est définie par la formule (IV) ci-dessous :

$$c(k) = (1 - b)c(k - 1) + bx(k) \qquad \text{(IV)}$$

Dans cette formule, x(k) est l'erreur résiduelle fréquentielle courante déterminée après correction par les moyens de calcul MC1. Par ailleurs, b est un coefficient compris entre 0 et 1.

Ce filtre FLT est un filtre adaptatif en ce sens que le coefficient b est défini dynamiquement. Plus précisément, à titre d'exemple on compare l'erreur fréquentielle résiduelle déterminée par les moyens de calcul MC1 à une valeur limite prédéterminée, ce que l'on a représenté par un comparateur COMP2 sur la figure 1. Cette valeur limite prédéterminée est par exemple égale à la fréquence symbole divisée par 7. Si l'erreur fréquentielle résiduelle est supérieure à cette valeur limite prédéterminée, on choisit le coefficient b proche de 1, par exemple égal à 1 tandis que le coefficient b est choisi proche de 0, par exemple égal à 0 si cette erreur fréquentielle résiduelle est inférieure à la valeur limite prédéterminée.

Ceci permet d'obtenir une convergence rapide vers la valeur cible de l'erreur fréquentielle et d'éviter des oscillations autour de cette valeur cible.

L'invention permet donc de corriger des erreurs fréquentielles résiduelles dans une plage de correction égale à la fréquence symbole. Il convient de noter à cet égard que si l'erreur fréquentielle résiduelle est proche en valeur absolue de la fréquence de Nyquist, la puissance du dirac décalé est proche de 0 et par conséquent il est très facile d'effectuer une mauvaise estimation de cette erreur fréquentielle. Ceci étant, ceci n'est absolument pas un problème pour le dispositif selon l'invention. En effet, si l'estimation est complètement fausse, il est pratiquement impossible d'avoir une seconde erreur d'estimation proche de la fréquence de Nyquist et l'on se situera alors dans l'un des deux cas qui ont été évoqués précédemment, c'est-à-dire soit une erreur fréquentielle résiduelle inférieure à la fréquence de Nyquist, soit supérieure à la fréquence de Nyquist en valeur absolue.

Par ailleurs, tout autre signal de contenu connu autre que le signal pilote, peut convenir pour le contrôle de fréquence selon l'invention.

**Revendications**

1. Procédé de contrôle automatique de la fréquence d'un oscillateur local d'un récepteur du type DS-CDMA, dans lequel on reçoit un signal connu à spectre fréquentiel étalé que l'on transforme en un signal numérique échantillonné formé de symboles et à spectre fréquentiel désétalé, on détermine pour chaque symbole une erreur fréquentielle résiduelle ($f_e$), on filtre (FLT) cette erreur et on corrige la fréquence de l'oscillateur local (VCO) avec cette erreur filtrée, **caractérisé par le fait qu'**on mémorise la première erreur fréquentielle résiduelle déterminée $f_{e1}$, on détermine la moyenne des valeurs absolues d'un nombre prédéterminé d'erreurs fréquentielles résiduelles successives, on compare cette moyenne à un seuil prédéterminé, et si cette moyenne est supérieure audit seuil, on corrige la fréquence de l'oscillateur local avec une erreur égale à $-\text{sgn}(f_{e1})(1/T - |f_{e1}|$, où sgn est la fonction " signe ", | | la fonction valeur absolue et T la durée d'un symbole, avant de déterminer l'erreur fréquentielle résiduelle suivante associée au symbole suivant.

2. Procédé selon la revendication 1, **caractérisé par le fait que** le filtrage des erreurs fréquentielles résiduelles est un filtrage numérique, et **par le fait que** si la moyenne est supérieure audit seuil, on met à zéro la mémoire du filtre numérique (FLT) avant de filtrer ladite erreur fréquentielle résiduelle suivante.

3. Procédé selon la revendication 1 ou 2, **caractérisé par le fait qu'**on filtre les erreurs fréquentielles résiduelles avec un filtre adaptatif du premier ordre (FLT).

4. Procédé selon la revendication 3, **caractérisé par le fait que** la correction courante appliquée à l'oscillateur local est égale à (1-b) fois la correction précédente plus b fois l'erreur fréquentielle résiduelle courante, et **par le fait que** le coefficient b est choisi proche de 1 si l'erreur fréquentielle résiduelle courante est supérieure à une première valeur limite prédéterminée, tandis que le coefficient b est choisi proche de 0 si l'erreur fréquentielle résiduelle courante est inférieure à une deuxième valeur limite prédéterminée.

5. Procédé selon la revendication 4, **caractérisé par le fait que** ladite valeur limite prédéterminée est égale à la fréquence symbole divisée par sept.

6. Dispositif de contrôle automatique de la fréquence d'un oscillateur local d'un récepteur du type DS-CDMA, comprenant une entrée pour recevoir un signal connu à spectre fréquentiel étalé, des moyens de prétraitement (MX, CAN) aptes à transformer ce signal en un signal numérique échantillonné formé de symboles et à spectre fréquentiel désétalé, des premiers moyens de calcul (MC1) aptes à déterminer pour chaque symbole une erreur fréquentielle résiduelle *(f$_e$)*, des moyens de filtrage (FLT) aptes à filtrer cette erreur et des moyens de correction (CNA) pour corriger la fréquence de l'oscillateur local (VCO) avec cette erreur filtrée, **caractérisé par le fait qu'**il comporte en outre une mémoire (MM) pour mémoriser la première erreur fréquentielle résiduelle déterminée $f_{e1}$, des deuxièmes moyens de calcul (MC2) aptes à déterminer la moyenne des valeurs absolues d'un nombre prédéterminé d'erreurs fréquentielles résiduelles successives, des moyens de comparaison (COMP1) aptes à comparer cette moyenne à un seuil prédéterminé, et si cette moyenne est supérieure audit seuil, les moyens de correction corrigent la fréquence de l'oscillateur local avec une erreur égale à -sgn($f_{e1}$)(1/T - | fe$_1$|), où sgn est la fonction " signe ", | | la fonction valeur absolue et T la durée d'un symbole, avant que les premiers moyens de calcul (MC1) ne déterminent l'erreur fréquentielle résiduelle suivante associée au symbole suivant.

**7.** Dispositif selon la revendication 6, **caractérisé par le fait que** les moyens de filtrage comporte un filtrage numérique (FLT), et **par le fait que** le dispositif comportent des moyens de contrôle (MCLT) aptes, si la moyenne est supérieure au seuil, à mettre à zéro la mémoire du filtre numérique (FLT) avant de filtrer ladite erreur fréquentielle résiduelle suivante.

**8.** Dispositif selon la revendication 6 ou 7, **caractérisé par le fait que** les moyens de filtrage comportent un filtre adaptatif du premier ordre (FLT).

**9.** Dispositif selon la revendication 8, **caractérisé par le fait que** la correction courante appliquée à l'oscillateur local est égale à (1-b) fois la correction précédente plus b fois l'erreur fréquentielle résiduelle courante, et **par le fait que** le coefficient b est choisi proche de 1 si l'erreur fréquentielle résiduelle courante est supérieure à une première valeur limite prédéterminée, tandis que le coefficient b est choisi proche de 0 si l'erreur fréquentielle résiduelle courante est inférieure à une deuxième valeur limite prédéterminée.

**10.** Dispositif selon la revendication 9, **caractérisé par le fait que** ladite valeur limite prédéterminée est égale à la fréquence d'échantillonnage divisée par 7.

**11.** Récepteur du type DS-CDMA, comportant un dispositif selon l'une des revendications 6 à 10.

**12.** Récepteur selon la revendication 11, **caractérisé par le fait qu'**il forme un téléphone mobile.

$$-\text{sgn}(f_{e1})\left(\frac{1}{T}-|f_{e1}|\right)$$

oui=1 | non=0

Itération
n ?

FIG.1

FIG.2

**Office européen des brevets**

**RAPPORT DE RECHERCHE EUROPEENNE**

Numéro de la demande

EP 02 01 5921

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | WO 02 29978 A (ERICSSON TELEFON AB L M ;BOTTOMLEY GREGORY (US); DENT PAUL (US); A) 11 avril 2002 (2002-04-11) --- | | H03J7/02 |
| A | EP 1 217 738 A (NIPPON ELECTRIC CO) 26 juin 2002 (2002-06-26) --- | | |
| A | EP 0 989 687 A (SHARP KK) 29 mars 2000 (2000-03-29) --- | | |
| A | EP 1 071 224 A (MATSUSHITA ELECTRIC IND CO LTD) 24 janvier 2001 (2001-01-24) --- | | |
| A,D | ALDO N. D'ANDREA AND UMBERTO MENGALI: "Design of Quadricorrelators for Automatic Frequency Control Systems" IEEE TRANSACTIONS ON COMMUNICATIONS, vol. 41, no. 6, juin 1993 (1993-06), pages 988-997, XP002225621 ----- | | |

| | |
|---|---|
| | DOMAINES TECHNIQUES RECHERCHES (Int.Cl.7) |
| | H03J H04B |

Le présent rapport a été établi pour toutes les revendications

| Lieu de la recherche | Date d'achèvement de la recherche | Examinateur |
|---|---|---|
| LA HAYE | 18 décembre 2002 | Peeters, M |

**ANNEXE AU RAPPORT DE RECHERCHE EUROPEENNE
RELATIF A LA DEMANDE DE BREVET EUROPEEN NO.**        EP 02 01 5921

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-12-2002

| Document brevet cité au rapport de recherche | | Date de publication | Membre(s) de la famille de brevet(s) | | Date de publication |
|---|---|---|---|---|---|
| WO 0229978 | A | 11-04-2002 | AU | 9386201 A | 15-04-2002 |
| | | | WO | 0229978 A2 | 11-04-2002 |
| EP 1217738 | A | 26-06-2002 | JP | 2002190765 A | 05-07-2002 |
| | | | CN | 1371180 A | 25-09-2002 |
| | | | EP | 1217738 A2 | 26-06-2002 |
| | | | US | 2002177458 A1 | 28-11-2002 |
| EP 0989687 | A | 29-03-2000 | US | 6289061 B1 | 11-09-2001 |
| | | | EP | 0989687 A2 | 29-03-2000 |
| | | | JP | 2000106535 A | 11-04-2000 |
| EP 1071224 | A | 24-01-2001 | JP | 3323453 B2 | 09-09-2002 |
| | | | JP | 2000232394 A | 22-08-2000 |
| | | | AU | 2326600 A | 29-08-2000 |
| | | | CA | 2327101 A1 | 17-08-2000 |
| | | | EP | 1071224 A1 | 24-01-2001 |
| | | | CN | 1296671 T | 23-05-2001 |
| | | | WO | 0048329 A1 | 17-08-2000 |

EPO FORM P0460